Europäisches Patentamt

European Patent Office

Office européen des brevets

(11) Veröffentlichungsnummer: **0 360 884**
**A1**

## EUROPÄISCHE PATENTANMELDUNG

(21) Anmeldenummer: 88115835.6

(51) Int. Cl.⁵: **H03K 5/24**

(22) Anmeldetag: 26.09.88

(43) Veröffentlichungstag der Anmeldung:
**04.04.90 Patentblatt 90/14**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**D-8000 München 2(DE)**

(72) Erfinder: **Zitta, Heinz**
**Grossattelstrasse 9**
**A-9580 Drobollach(AT)**

(54) **CMOS-Differentialkomparator mit Offsetspannung.**

(57) Zur Erzeugung einer eingeprägten Offsetspannung für einen Differentialkomparator wird eine Schaltungsanordnung in komplementärer MOS-Technik vorgeschlagen, bei der die Offsetspannung durch das Design der Transistoren eingeprägt wird. Dazu werden die Geometrien (W/L) der Eingangsdifferenztransistoren (M1, M2; M11, M12) symmetrisch und die Geometrien (W/L) der zugeordneten Lasttransistoren (M3, M4; M13, M14) unsymmetrisch ausgelegt, sowie die Geometrien (W/L) der Transistoren der Ausgangstreiberschaltung (M6 bis M9; M16, M17) an die so erzeugte Arbeitscharakteristik des Differentialkomparators angepasst.

# FIG 1

$$(W/L)M1 = (W/L)M2$$
$$(W/L)M4 = a \cdot (W/L)M3$$

EP 0 360 884 A1

## CMOS-Differentialkomparator mit Offsetspannung

Die Erfindung betrifft eine Schaltungsanordnung in komplementärer MOS-Technik nach dem Oberbegriff des Patentanspruchs 1.

In Schaltungsanwendungen besteht oftmals die Forderung, daß ein Differentialkomparator bei einer differentiellen Eingangsspannung von mehr als O V zwischen den Eingangsanschlüssen umschaltet. Bekannt ist, das Problem durch eine zusätzliche Beschaltung des Komparators zu lösen. So wird z.B. eine die gewünschte Offsetspannung erzeugende Spannungsquelle in Serie zu einem Eingangsanschluß des Komparators geschaltet. In der Veröffentlichung SGS Power Supply Application Manual, 1985, Seite 49 ist ein Strombegrenzungsverstärker im integrierten Schaltkreis UC 1524 A beschrieben, der einen bipolaren Komparator enthält und bei dem die Offsetspannung durch eine Stromquelle in Verbindung mit einem Widerstand R1 erzeugt wird. Zusätzlich ist ein weiterer Widerstand zur Kompensation von Basisströmen erforderlich.

Der Nachteil einer zusätzlichen Beschaltung für den Differentialkomparator, um die gewünschte Offsetspannung zu erzielen, besteht darin, daß zusätzliche Bauteile erforderlich sind und ein höherer Stromverbrauch auftritt. Andererseits sollen die Eigangstransistoren der Eingangsdifferenzstufe des Differentialkomparators möglichst symmetrisch und flächenmäßig gleich groß sein, um Fehlereinflüsse in der Eingangsdifferenzstufe möglichst gegen Null gehen zu lassen.

Der Erfindung liegt die Aufgabe zugrunde, eine Differentialkomparator-Schaltungsanordnung mit eingeprägter Offsetspannung anzugeben, die keine zusätzlichen Bauteile benötigt und den Stromverbrauch minimiert.

Diese Aufgabe wird bei einer Schaltungsanordnung der eingangs genannten Art erfindungsgemäß durch die Merkmale des kennzeichnenden Teils des Patentanspruchs 1 gelöst.

Die erfindungsgemäße Schaltungsanordnung besitzt den Vorteil, daß sich aufgrund der Realisierung des Differentialkomparators in komplementärer MOS-Technik die Geometrien der benötigten Transistoren einerseits sehr präzise und genau einstellen lassen und daß andererseits daraus präzise vorher berechenbare Werte für die eingeprägte Offsetspannung resultieren. Die erfindungsgemäße Schaltungsanordnung besitzt weiterhin den Vorteil, daß der Differentialkomparator bis knapp unterhalb der Versorgungsspannung ausgesteuert werden kann und daß die Schaltung deshalb mit einer geringen Versorgungsspannung auskommt. Durch die Realisierung in CMOS-Technik wird der Stromverbrauch minimal gehalten.

Weiterbildungen der Erfindung sind in Unteransprüchen gekennzeichnet.

Die Erfindung wird im folgenden anhand zweier in den Figuren der Zeichnung dargestellter Ausführungsbeispiele näher erläutert. Dabei sind gleiche Elemente mit gleichen Bezugszeichen versehen. Es zeigt

FIG 1 ein schematisches Schaltbild eines ersten Ausführungsbeispiels einer erfindungsgemäßen Schaltungsanordnung und

FIG 2 ein Schaltbild eines weiteren Ausführungsbeispiels einer erfindungsgemäßen Anordnung.

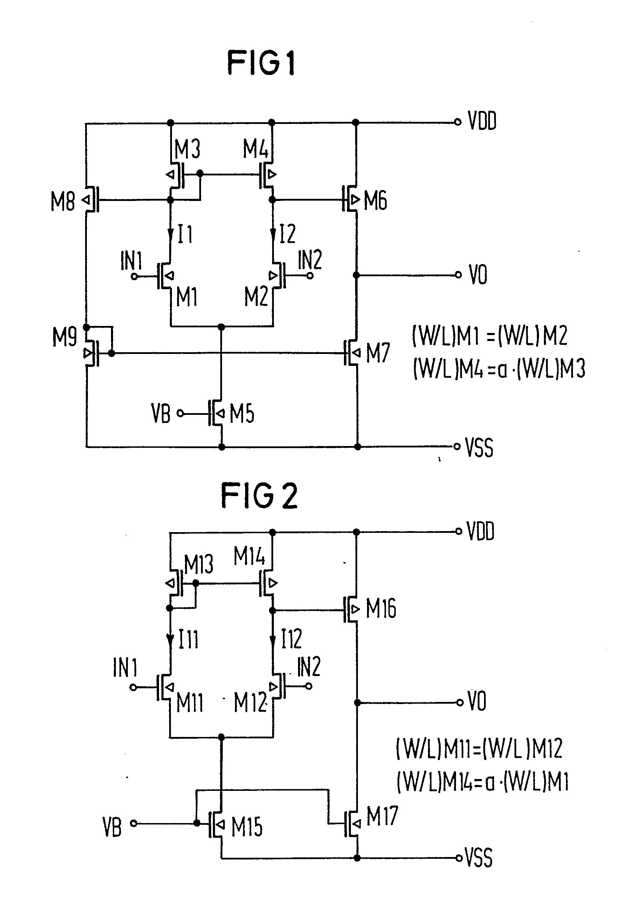

FIG 1 geht von einer Schaltungsanordnung in CMOS-Technik mit einem Differentialkomparator und einer Ausgangstreiberschaltung aus, wie sie in der Veröffentlichung ICC Berlin Continuing Enguieering Education Program, pp. 7.4.1-7.4.5 beschrieben ist. Der Komperator besteht aus den Transistoren M1 bis M5, der von einer Versorgungsspannungsquelle über die Klemmen VDD und VSS versorgt wird. Die Eingangsdifferenzstufe bilden die beiden Eingangstransistoren M1 und M2, die über die Eingangsanschlüsse IN1 und IN2 gesteuert werden. Beide Transistoren werden sourceseitig von einer Stromquelle gespeist, die aus dem Transistor M5 besteht, der über eine Klemme VB mit einer Bias-Spannung gesteuert wird. In den Ausgangskreisen der Eingangstransistoren M1 und M2 sind die Lasttransistoren M3 und M4 angeordnet. Beide Transistoren werden als Lastwiderstand betrieben, indem die Steueranschlüsse beider Transistoren miteinander und mit dem Drainanschluß des Transistors M3 verbunden sind. Der am Verbindungspunkt der Ausgangskreise der Transistoren M2 und M4 liegende Ausgangsanschluß des Differentialkomparators steuert die Ausgangsstufe einer Ausgangstreiberschaltung. Die Ausgangsstufe enthält die beiden mit ihren Ausgangskreisen in Reihe zwischen die Versorgungsspannung geschalteten Transistoren M6 und M7. Der Verbindungspunkt der Ausgangskreise von M6 und M7 bildet den Ausgang der Schaltungsanordnung. Während der Transistor M6 vom Ausgang des Komparators gesteuert wird, bildet der Transistor M7 einen Teil eines Stromspiegels, zu dem der Transistor M9 einer Referenzstufe gehört. Die Steueranschlüsse M7 und M9 sind miteinander und mit dem Drainanschluß von M9 verbunden. In Reihe zum Ausgangskreis von M9 liegt der Ausgangskreis eines Referenztransistors M8, der dem Ausgangstransistor M6 entspricht. Entsprechend wird M8 vom Verbindungspunkt der Ausgangskreise der Transistoren M1 und M3 gesteuert.

Erfindungsgemäß wird nun die eingeprägte Offsetspannung durch das Design bzw. die Dimensionierung der Geometrieverhältnisse der Transistoren der Schaltungsanordnung erzeugt. Die Eingangstransistoren M1 und M2 werden symmetrisch ausgelegt und die Lasttransistoren M3 und M4 unsymmetrisch. Die Geometrien der Transistoren der Ausgangstreiberschaltung M6 bis M9 werden erfindungsgemäß an die Arbeitscharakteristik des Differentialkomparators angepasst.

Erreicht werden diese Maßnahmen dadurch, daß die Geometriequotienten aus der Kanalweite und der Kanallänge der Transistoren entsprechend dimensioniert werden. Das Verhältnis der Geometriequotienten der Transistoren M1 und M2 wird gleich gewählt. Da sich in der MOS-Technik gleiche Strukturen sehr präzise herstellen lassen, werden auf diese Weise Streuungen, die durch die Eingangsstufe hervorgerufen werden, weitgehend eliminiert. Die Geometrie quotienten aus Kanalweite und Kanallänge des Lasttransistors M4 bezogen auf den Lasttransistor M3 wird auf einen Wert a eingestellt, der größer 1 ist. Die Größe dieses Werts a bestimmt zusammen mit der geometrieunabhängigen Transistorkonstanten k für die Transistoren M1 und M2 die Größe der Offsetspannung.

Die Anpassung der Geometrien der Ausgangstreiberschaltung geschieht durch die Erfüllung der nachfolgenden Bedingung:

$$\frac{(W/L)M6}{(W/L)M4} * a = \frac{(W/L)M8}{(W/L)M3} * \frac{(W/L)M7}{(W/L)M9}$$

Durch Einsetzen der Beziehung zwischen dem Wert a und den Transistoren M3 und M4 folgt die Dimensionierungsvorschrift, daß der Geometriequotient des Ausgangstransistors M6 gleich ist dem Produkt aus den Geometriequotienten des Referenztransistors M8 und dem Verhältnis der Geometriequotienten des Ausgangskomplementärtransistors M7 bezogen auf den Referenzkomplementärtransistor M9, die den Stromspiegel bilden:

$$(W/L)M6 = (W/L)M8 * \frac{(W/L)M7}{(W/L)M9}$$

Entsprechend der Dimensionierung des Komparators ist der durch den Transistor M2 fließende Strom I2 um dem Faktor a größer als der durch den Transistor M1 fließende Strom I1. Die Summe der Zweigströme I1 und I2 ergibt den von der Stromquelle M5 gelieferten Bias-Strom. Aus der Beziehung für den Sättigungsstrom der Transistoren M1 und M2

$I = (k/2) * (W/L) * (Vgs - Vt)^2$

läßt sich dann die Offsetspannung Vd berechnen. Es ergibt sich die Formel

$$Vd = \frac{\sqrt{I1} - \sqrt{I2}}{(k/2) * (W/L)}$$

In diesen Formeln bezeichnet k die geometrieunabhängige Transistorkonstante und W/L den Geometriequotienten der Transistoren M1 und M2, Vgs die Gate-Source-Spannung und Vt die Schwellenspannung der Transistoren.

Gemäß dem Ausführungsbeispiel der FIG 2 wird die Erfindung an einer weiteren CMOS-Schaltungsanordnung erläutert, die aus der Veröffentlichung IEEE ISSC Vol. Sc-17, No. 6, DEC 1982, pp. 969-982 bekannt ist. Die Schaltung weist einen entsprechend der FIG 1 aus den Transistoren M11 bis M15 aufgebauten Differentialkomparator auf. Im Gegensatz zur FIG 1 wird jedoch keine separate Referenzstufe vorgesehen, sondern der Ausgangskomplementärtransistor M17 wird ebenso wie der Stromquellentransistor M15 gemeinsam über eine Klemme VB von einer Bias-Spannung gesteuert. Der Ausgang des Komparators am Verbindungspunkt der Ausgangskreise der Transistoren M12 und M14 steuert den Ausgangstransistor M16, dessen Drainanschluß den Ausgang der Schaltungsanordnung bildet.

Für die Dimensionierung der Geometriequotienten der Komparatortransistoren gilt das gleiche wie für die Komparatortransistoren der FIG 1. So wird der Geometriequotient aus Kanalweite und Kanallänge für die Transistoren M11 und M12 gleich gewählt. Das Verhältnis der Geometriequotienten der Lasttransistoren M14 bezogen auf M13 ist gleich dem Wert a. Zur Anpassung der Ausgangstreiberschaltung aus den Transistoren M16 und M17 muß noch folgende Bedingung gegeben sein

$$\frac{(W/L)M16}{(W/L)M14} * a = \frac{(W/L)M17}{(W/L)M15} * (1+a).$$

Nach Einsetzen des für den Wert a angegebenen Verhältnisses für die Transistoren M14 und M13 ergibt sich, daß das Verhältnis der Geometriequotienten des Ausgangstransistors M16 zum ersten Lasttransistor M13 gleich ist dem Produkt aus dem Verhältnis der Geometriequotienten des Ausgangskomplementärtransistors M17 und des Stromquellentransistors M15 einerseits und dem um 1 erhöhten Verhältnis der Geometriequotienten des zweiten Lasttransistors M14 bezogen auf den ersten Lasttransistor M13.

**Ansprüche**

1. Schaltungsanordnung in komplementärer MOS-Technik mit einem Komparator (M1 bis M5; M11 bis M15), bei dem zwei eine Eingangsdifferenzstufe bildende Eingangstransistoren (M1, M2; M11, M12) von einer Stromquelle (M5; M15) gespeist werden und einen ersten (M3; M13) und zweiten (M4; M14) Lasttransistor treiben, und mit einer Ausgangstreiberschaltung (M6 bis M9; M16, M17), die wenigstens einen vom Komparatorausgang gesteuerten Ausgangstransistor (M6, M16) und dessen Ausgangskomplementärtransistor (M7, M17) enthält,
**dadurch gekennzeichnet**, daß die Geometrien der Eingangstransistoren (M1, M2; M11, M12) symmetrisch und die Geometrien der Lasttransistoren (M3, M4; M13, M14) unsymmetrisch sind sowie, daß die Ausgangstreiberschaltung (M6 bis M9; M16, M17) geometriemäßig an die dadurch erzeugte Arbeitscharakteristic des Komparators angepasst ist.

2. Anordnung nach Anspruch 1,
**dadurch gekennzeichnet**, daß das Verhältnis der Geometriequotienten (W/L) aus Kanalbreite und Kanallänge für die Eingangstransistoren (M1, M2; M11, M12) gleich eins und für den dem Ausgang zugeordneten zweiten Lasttransistor (M4; M14) bezüglich des ersten Lasttransistors (M3; M13) größer eins ist.

3. Anordnung nach Anspruch 1 oder 2,
**dadurch gekennzeichnet**, daß der Geometriequotient des Ausgangstransistors (M6) gleich ist dem Produkt aus dem Geometriequotienten eines dem Ausgangstransistor (M6) entsprechenden Referenztransistor (M8) und dem Verhältnis der Geometriequotienten eines aus dem Ausgangskomplementärtransistor (M7) und einem Referenzkomplementärtransistor (M9) gebildeten Stromspiegels.

4. Anordnung nach Anspruch 1 oder 2,
**dadurch gekennzeichnet**, daß das Verhältnis der Geometriequotienten des Ausgangstransistors (M16) zum ersten Lasttransistor (M13) gleich ist dem Produkt aus dem Verhältnis der Geometriequotienten des Ausgangskomplementärtransistors (M17) und eines die Stromquelle bildenden Transistors (M15) einerseits und dem um 1 erhöhten Verhältnis der Geometriequotienten des zweiten (M14) und des ersten (M13) Lasttransistors andererseits.

# FIG 1

$(W/L)M1 = (W/L)M2$

$(W/L)M4 = a \cdot (W/L)M3$

# FIG 2

$(W/L)M11 = (W/L)M12$

$(W/L)M14 = a \cdot (W/L)M1$

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.3) |
|---|---|---|---|
| X | US-A-4 047 059 (B.D. ROSENTHAL) * Spalte 3, Zeilen 36-41; Spalte 4, Zeile 46 - Spalte 5, Zeile 38; Anspruch 10; Figur 2 * --- | 1,2 | H 03 K 5/24 |
| A,D | IEEE JOURNAL OF SOLID-STATE CIRCUITS, Band SC-17, Nr. 6, Dezember 1982, Seiten 969-981, IEEE, New York, US; P.R. GRAY et al.: "MOS operational amplifier design - A tutorial overview" * Absatz III * --- | 1 | |
| A | US-A-4 658 157 (M.C. McGOWAN) --- | | |
| A | RADIO FERNSEHEN ELEKTRONIK, Band 27, Nr. 10, Oktober 1978, Seiten 621-625, VEB Verlag Technik, Berlin, DD; H.-E. KRÖBEL: "Grundschaltungen der analogen integrierten Technik" ----- | | |

**RECHERCHIERTE SACHGEBIETE (Int. Cl.3)**

H 03 K
H 03 F
G 05 F
G 01 R

Der vorliegende Recherchenbericht wurde für alle Patentansprüche erstellt

| Recherchenort | Abschlußdatum der Recherche | Prüfer |
|---|---|---|
| DEN HAAG | 17-05-1989 | BLAAS D.-L.A.J. |